**Europäisches Patentamt**

**European Patent Office**

**Office européen des brevets**

(19)

(11) Veröffentlichungsnummer: **0 171 463**
**B1**

(12) **EUROPÄISCHE PATENTSCHRIFT**

(45) Veröffentlichungstag der Patentschrift: **27.06.90**

(21) Anmeldenummer: **84114584.0**

(22) Anmeldetag: **30.11.84**

(51) Int. Cl.⁵: **H 05 K 7/14**

(54) **Gehäuse für die Aufnahme elektrischer Bauelemente.**

(30) Priorität: **14.08.84 DE 3429894**

(43) Veröffentlichungstag der Anmeldung:
**19.02.86 Patentblatt 86/08**

(45) Bekanntmachung des Hinweises auf die
Patenterteilung:
**27.06.90 Patentblatt 90/26**

(84) Benannte Vertragsstaaten:
**AT BE CH DE FR GB IT LI LU NL SE**

(56) Entgegenhaltungen:
**EP-A-0 109 569**
**DE-A-2 515 163**
**DE-A-3 144 131**
**DE-U-8 230 232**
**US-A-3 164 432**

(73) Patentinhaber: **Reinhardt, Rudolf**
**Markt-Schwabener-Strasse 2**
**D-8059 Finsing (DE)**

(72) Erfinder: **Reinhardt, Rudolf**
**Markt-Schwabener-Strasse 2**
**D-8059 Finsing (DE)**

(74) Vertreter: **Kern, Wolfgang, Dipl.-Ing. et al**
**Patentanwälte Kern, Brehm & Partner Albert-**
**Rosshaupter-Strasse 73**
**D-8000 München 70 (DE)**

Courier Press, Leamington Spa, England.

## Beschreibung

Die Erfindung betrifft ein Gehäuse als Einschubmodul für das 19-Zoll-Gerätesystem zur Aufnahme elektrischer Bauelemente, mit einem stranggepreßten, aus Aluminium bestehenden U-Profilkörper, dessen Außenabmessungen dem Gehäuse entsprechen und der auf seinen einander gegenüberliegenden parallelen Seitenwänden Profilierungen zur Befestigung von elektrischen Bauelementen sowie zur Befestigung von Gehäusedeckelelementen, Seitenteilen und Tragkörpern aufweist.

Es sind langgestreckte Gehäuse bekannt, die eine Vielzahl von in Reihe nebeneinander angeordneten elektrischen Steckdosen aufnehmen sowie Schalter, Kontrollampen u. dgl. Solche Gehäuse sind längs teilbar und bestehen somit aus einem oberen und einem unteren trogförmigen Halbgehäuse, in denen jeweils ein Teil der Steckdosen gehaltert ist und die durch Schrauben zusammengehalten werden, welche gleichzeitig die Steckdosenteile miteinander verbinden.

Derartige Gehäuse können mit Zusatzgehäusen für die Aufnahme notwendiger elektrischer Bauelemente und ihrer Verdrahtung versehen werden, die sich mit Hilfe von an den Hauptgehäusen vorhandenen Rastverbindungen für die Abschlußdeckel mit den Hauptgehäusen so verbinden lassen, daß zwischen den Standardbauelementen der Hauptgehäuse und den elektrischen Bau- und Schaltelementen der Zusatzgehäuse die für den jeweiligen Schaltzweck erforderlichen Verbindungen hergestellt werden können (DE-GM 82 30 232).

Es sind ferner Leergehäuse zur Aufnahme von Frontplattenmodulen in 1/2 und 1/4 Teilung bekannt. Die mit den Frontplattenmodulen komplett montiert zur Verfügung gestellt werden. Derartige Einschubmodule erfordern jedoch insofern einen erheblichen Fertigungs- und Montageaufwand, als ihre elektrische Ausstattung auf speziellen Montageelementen, wie Führungsschienen, Kabelschächten, Montageebenen, die separat hergestellt werden müssen und separat im Leergehäuse befestigt werden müssen, anzubringen ist. Derartige im Handel erhältliche sogenannte Systemnetzversorgungseinschübe sind deshalb nur nach Anpassung an die jeweiligen gewünschten elektrischen Einbauten verwendbar, und diese Anpassung erfordert zeitraubende und kostspielige Handarbeit, auch wenn die oben genannten Einbauelemente, also beispielsweise Montageebenen, Kabelschächte und Führungsschienen zur Verfügung stehen.

Es ist ferner ein Gehäuse für ein mindestens eine Leiterplatte enthaltendes Gerät der Steuer-, Meß-, Regel- oder Datenverarbeitungstechnik bekannt (DE-A-31 44 131), das zur Aufnahme von Leiterplatten geeignet ist.

Die aus der DE-A-25 14 163 bekannte Mehrzweckprofilschiene zeigt Möglichkeiten zur schnellen Befestigung elektrischer Bauelemente auf der Schienenoberfläche.

Aus der EP-A-109 569 ist ein Einschub für einen elektrischen Anlagenschrank bekannt, der aus einer Vielzahl von Wand- und Bodenteilen zusammengesetzt ist.

Die Aufgabe der Erfindung besteht deshalb darin, ein Gehäuse der eingangs genannten Art so auszubilden, daß es universell verwendbar ist, und es den Einbau von elektrischen Bauelementen ermöglicht, ohne daß eine Vorbereitung oder Anpassung des Gehäuses an derartige Bauelemente erforderlich ist.

Diese Aufgabe wird erfindungsgemäß dadurch gelöst, daß der U-Profilkörper des Gehäuses auf der Innenseite seiner Bodenwand, an die die Seitenwände anstoßen, mit wenigstens einer in Profilkörperlängsrichtung laufenden Profilschiene mit seitlichen Schnappbefestigungselementen versehen ist, durch die elektrische Bauelemente, wie Sicherungsautomaten, Steckdosen, Schaltrelais, Widerstände o. dgl. durch Aufstecken auf und Einrasten in die Profilschiene in dem Gehäuse lösbar und austauschbar befestigbar sind, daß auf der Innenseite der Bodenwand zwischen den in ihrer Mitte angeordneten beiden parallelen Schienen und den Außenrändern Montagevertiefungen ausgebildet sind, an die sich seitlich daran anschließend je ein Montagekanal erstreckt, unterhalb derer sich auf der Außenseite des Bodens Längsnuten zur Befestigung von Winkelkörpern, Stirnseitenwänden und Traggriffen befinden, und daß sich auf den Innenseiten der Seitenwände des U-Profilkörpers parallel zu der Bodenwand verlaufende Profilierungen befinden, die sich zum Inneren des Profilkörpers hin öffnen.

Durch diese Gehäuseausbildung wird erreicht, daß die Montageebenen, Kabelschächte und Führungsschienen Bestandteil eines stranggepreßten U-Profilkörpers sind, also nicht separat hergestellt und in das Leergehäuse eingebaut werden müssen. Da die Herstellung eines solchen U-Profilkörpers im Stranpreßverfahren, wenn überhaupt, dann nicht wesentlich teurer ist als die Herstellung bekannter Leergehäuse für den genannten Verwendungszweck, ergibt sich bereits dadurch, daß separate Einbauteile als Halterungs- oder Führungselemente für die elektrischen Bauelemente nicht mehr benötigt werden, eine erhebliche Herstellungskostenreduzierung. Außerdem entfällt der Montageaufwand der separaten Halterungsund Führungselemente.

Vorteilhafte Ausgestaltungen der Erfindung sind in den Unteransprüchen gekennzeichnet.

Die Erfindung wird nachfolgend anhand des in der Zeichnung dargestellten Ausführungsbeispiels näher erläutert. In der Zeichnung zeigt:

Fig. 1 eine perspektivische Draufsicht des erfindungsgemäßen Gehäuses mit an ihm befestigten Seitenwänden und Tragelementen, wobei die elektrischen Bauteile weggelassen sind und

Fig. 2 eine perspektivische Teilschnittansicht des U-Profilkörpers, aus dem das Gehäuse von Fig. 1 gefertigt ist.

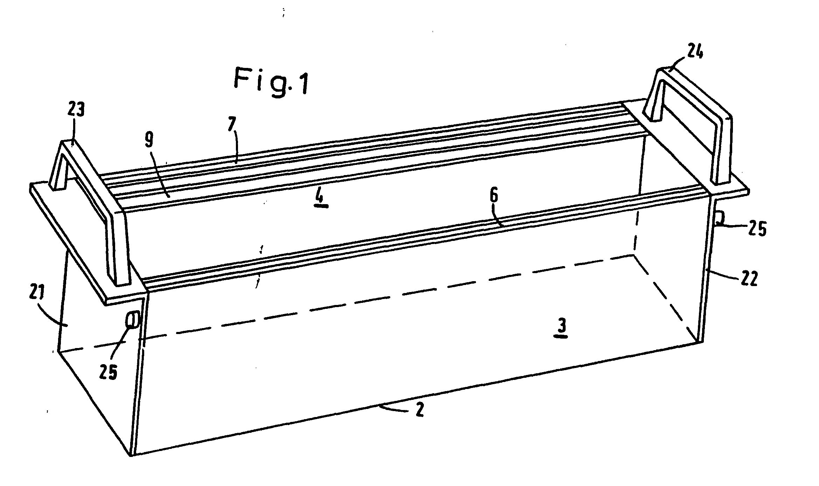

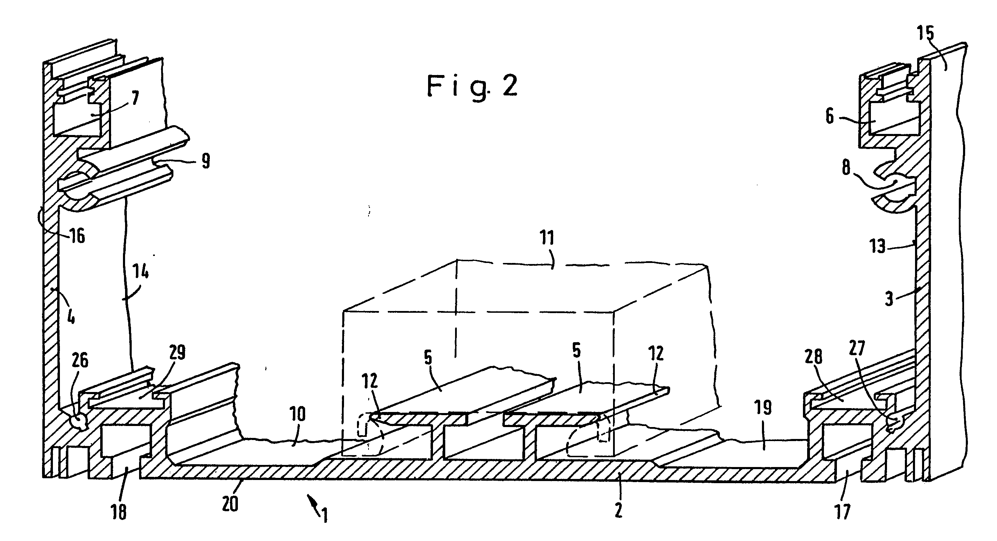

Das in Fig. 1 gezeigte Gehäuse für die Aufnahme elektrischer Bauelemente ist als Einschubmodul für das 19 Zoll-Gerätesystem ausgebildet und besteht aus einem in Fig. 2 in perspektivischer, geschnittener Darstellung im Detail zu sehenden U-Profilkörper 1 mit den mit Abstand gegenüberliegenden, parallelen Seitenwänden 3 und 4 und der Bodenwand 2 sowie den an den Stirnseiten dieses Profilkörpers bei 25 angeschraubten Stirnseitenwänden 21 und 22, deren obere Enden zur Bildung von Traggriffen 23 und 24 nach außen abgebogen sind. Die Außenabmessungen dieses Gehäuses entsprechen somit denjenigen des Einschubmoduls.

Die Bodenwand 2 sowie die beiden Seitenwände 3 und 4 sind mit Profilierungen zur Befestigung und Führung elektrischer und mechanischer Bauelemente versehen, wie dies im folgenden im einzelnen erläutert wird. Diese Profilierungen sind somit Bestandteil des aus Aluminium bestehenden, stranggepreßten U-Profilkörpers 1 und hinsichtlich ihrer Formgebung an den jeweiligen Verwendungs- bzw. Benutzungszweck von Hause aus angepaßt.

Auf der Innenseite 10 der Bodenwand 2 befinden sich zwei in Profilkörperlängsrichtung verlaufende Schienen 5, die als Schnappbefestigungselemente für die auf dieser Innenseite zu befestigenden elektrischen Bauelemente, beispielsweise Schalter, Steckdosen und Sicherungen, dienen und von denen schematisch in Fig. 2 in gestrichelten Linien bei 11 eines dargestellt ist. Diese Schnappbefestigungselemente 12 rasten in am Boden der elektrischen Bauelemente befindliche, entsprechende Aussparungen ein. Andererseits ist die Möglichkeit gegeben, falls die elektrischen Bauelemente bodenseitig nicht verformbar sind, um eine Schnapp wirkung der beschriebenen Art zu erzielen, die elektrischen Bauelemente seitlich auf die Schienen aufzuschieben und, falls erforderlich, durch zwischengefügte, verformbare Kunststoffhalterungen daran zu hindern, sich nach ihrer Montage auf den Schienen von selbst zu verschieben.

Auf den Innenseiten 13 und 14 der Seitenwände 3, 4 sind ebenfalls Profilierungen ausgebildet, und zwar in Form von Profillängsrichtung verlaufenden Nuten 6 und 7 zur Befestigung wenigstens einer nicht dargestellten Frontplatte an dem Profilkörper, die diesen nach oben hin abschließt und entweder als geschlossene Abdeckung ausgeführt ist oder Durchbrüche aufweist, die die in dem Gehäuse auf den Schienen 5 befestigten elektrischen Bauelemente zugänglich machen. Ferner sind an den genannten Innenseiten Profilierungen 8, 9 zu finden, die Schraubkanäle bilden, welche zur Befestigung von den Profilkörper seitlich verschließenden, plattenförmigen Stirnseiten 21 und 22 mit Hilfe der bei 25 in Fig. 1 gezeigten Schrauben dienen. Des weiteren sind im Bereich des Bodens 2 ebenfalls auf der Innenseite der Seitenwände parallele Schachtkanäle für die Verdrahtung der elektrischen Bauelemente zu finden und auf der Außenseite 20 der Bodenwand 2 Längsnuten 17, 18 zur Befestigung von Winkelkörpern und anderer Verbindungselemente, mit denen zwei derartige Gehäuse, Boden an Boden miteinander verbunden werden können.

Die Außenseiten 15, 16 der beiden Seitenwände 3, 4 sind bei dem hier beschriebenen Ausführungsbeispiel glatt, weisen also keine Profilierungen auf, obgleich solche denkbar wären, beispielsweise als Führungselemente für etagenweise übereinander anzuordnende Gehäuse dieser Art.

Die Innenseite 10 der Bodenwand 2 ist zwischen den in ihrer Mitte angeordneten beiden parallelen Schienen 5 und den Außenrändern mit Montagevertiefungen 19 versehen. Seitlich daran anschließend erstreckt sich zu beiden Seiten je ein Kanal 28 und 29, der ebenfalls zu Montagezwecken dient.

Somit beinhaltet der U-Profilkörper in Form geeigneter Profilierungen alle Halterungs- und Führungselemente für die in das Gehäuse einzubauenden elektrischen Bauteile, ohne daß diese Elemente vor der Montage der Bauteile noch bearbeitet oder in irgendeiner Weise geändert werden müssen, um die elektrischen Bauelemente aufnehmen zu können.

**Patentanspruch**

Gehäuse als Einschubmodul für das 19-Zoll-Gerätesystem zur Aufnahme elektrischer Bauelemente, mit einem stranggepreßten, aus Aluminium bestehenden U-Profilkörper, dessen Außenabmessungen dem Gehäuse entsprechen und der auf seinen einander gegenüberliegenden parallelen Seitenwänden Profilierungen zur Befestigung von elektrischen Bauelementen sowie zur Befestigung von Gehäusedeckelelementen, Seitenteilen und Tragkörpern aufweist, dadurch gekennzeichnet, daß der U-Profilkörper (1) des Gehäuses auf der Innenseite (10) seiner Bodenwand (2), an die die Seitenwände (3, 4) anstoßen, mit wenigstens einer in Profilkörperlängsrichtung laufenden Profilschiene (5) mit seitlichen Schnappbefestigungselementen (12) versehen ist, durch die elektrische Bauelemente, wie Sicherungsautomaten, Steckdosen, Schaltrelais, Widerstände durch Aufstecken auf und Einrasten in die Profilschiene (5) in dem Gehäuse lösbar und austauschbar befestigbar sind, daß auf der Innenseite (10) der Bodenwand (2) zwischen den in ihrer Mitte angeordneten beiden parallelen Schienen (5) und den Außenrändern Montagevertiefungen (19) ausgebildet sind, an die sich seitlich daran anschließend je ein Montagekanal (28, 29) erstreckt, unterhalb derer sich auf der Außenseite (20) des Bodens (2) Längsnuten (17, 18) zur Befestigung von Winkelkörpern, Stirnseitenwänden (21, 22) und Traggriffen (23, 24) befinden, und daß sich auf den Innenseiten (13, 14) der Seitenwände (3, 4) des U-Profilkörpers (1) parallel zu der Bodenwand (2) verlaufende Profilierungen (8, 9) befinden, die sich zum Inneren des Profilkörpers hin öffnen.

**Revendication**

Réceptacle en forme de tiroir pour un système d'appareillage 19 pouces, destiné à l'incorporation de modules électriques, comportant un corps profilé en U réalisé en aluminium extrudé dont les dimensions extérieures sont celles dudit réceptacle et qui présente sur ses parois latérales parallèles se faisant réciproquement vis-à-vis des formes profilés destinées à la fixation de modules électriques ainsi qu'à la fixation de couvercle de fermeture du réceptacle, de parois frontales et de poignées, caractérisé en ce que le corps profilé en U (1) du réceptacle est pourvu sur la face interne (10) de son fond (2) contre lequel aboutissent les parois latérales (3, 4), d'au moins une glissière (5) s'étendant longitudinalement dans le sens du corps profilé et comportant des éléments latéraux de fixation par enclenchement (12) grâce auxquels des modules électriques tels que des automates de sécurité, des socles de prises de courant, des relais de commutation, des résistances peuvent être fixés de façon amovible et remplaçable dans le réceptacle, par enfichage sur, et encliquetage dans lesdites glissières profilées (5), en ce que des dépressions de montage (19) sont formées sur la face interne (10) du fond (2) entre les deux glissières (5) parallèles disposées en son milieu et ses bords externes, dépressions quelles se raccorde directement et latéralement un canal de montage (28, 29) en dessous duquel est située de chaque côté sur la face externe (20) du fond (2) une gorge longitudinale (17, 18) pour la fixation de cornières, de parois frontales (21, 22) et de poignées (23, 24) et en ce que des organes profilés (8, 9) ouverts vers l'intérieur du corps profilé s'étendent parallèlement au fond (2) et sont situées sur les faces internes (13, 14) des parois latérales (3, 4) du corps profilé en U (1).

**Claim**

A housing as slide-in module for the 19-inch-apparatus system for receiving electric structural elements, comprising an estruded U-profile member of aluminum the dimensions of which correspond to the housing and which is provided on its opposing, parallel side walls with profile means for the attachment of electric structural elements as well as for the attachment of cover elements of housings, lateral parts and supporting members, characterized in that said U-profile member (1) of the housing is provided on the inner side (10) of its bottom wall (2), to which the side walls (3, 4) are contiguous, with at least one profile rail (5) extending in longitudinal direction of the profile member including lateral snap-fastening elements (12), by which electric structural elements, such as automatic cut-outs, sockets, switching relays, resistances, can releasably and interchangeably be fastened in the housing by means of slipping them on and locking them in the profile rail (5) that on the inner side (10) of bottom wall (2) mounting recesses (19) are located between the two parallel rails (5) in the center of said wall and the outer edges, each of these recesses is laterally connected to a mounting channel (28, 29) below thereof and at the outer side (20) of the bottom (2) longitudinal grooves (17, 18) are provided for the attachment of angle members, front end walls (21, 22) and supporting handles (23, 24), and that on the inner sides (13, 14) of the side walls (3, 4) of said U-profile member (1) there are profile means (8, 9) extruding parallel the bottom wall (2) and opening themselves to the inside of said profile member.

Fig.1

# Fig. 2

EP 0 171 463 B1